# EUROPÄISCHE PATENTSCHRIFT

(11) **EP 3 790 177 B1**
(45) Veröffentlichungstag und Bekanntmachung des Hinweises auf die Patenterteilung: **01.05.2024**
(21) Anmeldenummer: 19196206.7
(22) Anmeldetag: 09.09.2019
(51) Int. Cl.: H02M 1/32, H02P 3/12, H02H 7/08

(54) **VERFAHREN ZUM BETREIBEN EINES ELEKTRISCHEN BEARBEITUNGSGERÄTS UND ELEKTRISCHES BEARBEITUNGSGERÄT**
ELECTRIC PROCESSING DEVICE AND METHOD FOR OPERATING SAME
PROCÉDÉ DE FONCTIONNEMENT D'UN APPAREIL D'USINAGE ÉLECTRIQUE ET APPAREIL D'USINAGE ÉLECTRIQUE

(43) Veröffentlichungstag der Anmeldung: 10.03.2021
(73) Patentinhaber: Andreas Stihl AG & Co. KG, 71336 Waiblingen (DE)
(72) Erfinder: Schmidt, Tobias, 73734 Esslingen (DE); Gurr, Kay-Steffen, 74078 Heilbronn (DE); Sämann, Marc, 72351 Geislingen (DE); Sämann, Rudolf, 72336 Balingen (DE)
(74) Vertreter: Patentanwälte Ruff, Wilhelm, Beier, Dauster & Partner mbB

(56) Entgegenhaltungen:
- EP-A1- 3 074 187
- EP-B1- 2 875 905
- EP-B1- 3 074 187
- JP-A- 2019 118 963
- JP-B2- 5 002 979
- US-A- 4 893 067
- US-A1- 2017 217 004

## Beschreibung

### ANWENDUNGSGEBIET UND STAND DER TECHNIK

Die Erfindung bezieht sich auf ein Verfahren zum Betreiben eines elektrischen Bearbeitungsgeräts und ein elektrisches Bearbeitungsgerät.

Die US 2017/0217004 A1 offenbart ein Werkzeug zum Eintreiben von Befestigungselementen. Das Werkzeug ist mit einem Kolben, einer Schlagfeder, einem Motor, einem Antriebsmechanismus, einer Motorantriebssteuereinheit, einer Positionserfassungseinheit und einer Zeitgebereinheit versehen. Der Antriebsmechanismus bewegt den Kolben durch Drehung des Motors von einer Stoppposition zum oberen Totpunkt. Die Schlagfeder bewegt den Stößel in Antriebsrichtung. Die Positionserfassungseinheit erfasst durch die Drehung des Motors, dass der Kolben eine vorbestimmte Position erreicht hat, und die Zeitgebereinheit misst die Zeit dazwischen. Die Motorantriebssteuereinheit führt, nachdem die Stromversorgung des Motors unterbrochen wurde, eine Stoppsteuerung zum Stoppen des Motors an der vorbestimmten Stoppposition basierend auf der von der Zeitgebereinheit gemessenen Zeit durch.

Die EP 3 074 187 A1 offenbart ein Elektrowerkzeug umfassend einen Motor, eine Verbindungseinheit und eine Steuerung. Die Verbindungseinheit ist konfiguriert, um mit einer Sekundärbatterie verbunden zu werden. Eine Spannungserkennungseinheit ist dazu konfiguriert, eine Spannung der Sekundärbatterie zu erkennen, die mit der Verbindungseinheit verbunden ist. Die Steuerung ist dazu konfiguriert, eine Änderung der erfassten Spannung zu erfassen. Die Steuerung schränkt den Betrieb des Motors ein, wenn die Spannungsänderung ein erster Wert ist.

Die JP 2019 118963 A offenbart um einen Bruch einer Einrichtung wie eines Wechselrichterkreises usw. zu verhindern folgende Lösung: Ein Elektrowerkzeug umfasst einen Steuerteil zum Steuern eines Drehantriebs eines Motors. Der Steuerteil umfasst eine Schalteinrichtung, eine Diode, eine Wechselrichterschaltung, eine Steuerschaltung und Spannung/Stromerfassungsmittel. Wenn die Schalteinrichtung ausgeschaltet wird und die Steuerschaltung wiederholt Schaltelemente unter mehreren Schaltelementen gleichzeitig ein- und ausschaltet, so dass der Motor sanft gebremst wird, wenn die Spannung/Stromerfassungsmittel eine Spannung/einen Strom höher als einen vorgeschriebenen Wert in der Wechselrichterschaltung durch einen regenerativen Strom erzeugt durch den Motor erfassen, wird die Ausführung der sanften Bremsung durch die Steuerschaltung gestoppt.

Die US 4 893 067 A offenbart, dass ein Motordrehzahl-Steuerschaltung eine durchschnittliche Gegen-EMK als Maß für eine Motordrehzahl erfasst. Die Gegen-EMK lädt eine Kondensatorschaltung, die Ladung akkumuliert und eine Spannung entwickelt, die die Motordrehzahl anzeigt. Eine Abtast- und Halteschaltung kann verwendet werden, um die Gegen-EMK abzutasten, wenn der Motor während jedes Zyklus ausgeschaltet wird. Diese Spannung wird mit einer Referenzspannung verglichen, die die gewünschte Motordrehzahl anzeigt. Durch Vergleichen der Solldrehzahl mit der Istdrehzahl wird ein Fehlersignal erzeugt, und dieses Fehlersignal wird verwendet, um eine Impulsfolge mit variablem Tastverhältnis zu erzeugen, die einen Leistungssteuertransistor ein- und ausschaltet, um die Motordrehzahl zu steuern. Eine logisch gesteuerte oder SCR-gesteuerte Spannungserhöhungsschaltung arbeitet synchron mit der Ansteuerimpulsfolge, um den Leistungstransistor hart in Sättigung zu treiben. Dies senkt den Widerstand des Leistungstransistors und verursacht weniger Energieverlust als Abwärme. Die Motordrehzahl-Steuerschaltung erzeugt eine Familie von Drehmoment-Drehzahl-Kurven, die die Drehzahl konstant halten, bis ein Knickpunkt erreicht ist, woraufhin die Drehzahl umgekehrt proportional zum Drehmoment abfällt. Eine Drehmomentsteuerschaltung überwacht den Motorstrom und hält diesen Strom auf einem vom Benutzer ausgewählten Pegel, um dadurch ein gewünschtes Ausgangsdrehmoment auszuwählen.

Die JP 5 002979 B2 offenbart eine Gleichstrommotorkontrollschaltung.

Die EP 2 875 905 B1 offenbart eine Schaltvorrichtung für Gartengeräte.

### AUFGABE UND LÖSUNG

Der Erfindung liegt als Aufgabe die Bereitstellung eines Verfahrens zum Betreiben eines elektrischen Bearbeitungsgeräts und eines elektrischen Bearbeitungsgeräts zugrunde, das jeweils verbesserte Eigenschaften aufweist.

Die Erfindung löst diese Aufgabe durch die Bereitstellung eines Verfahrens mit den Merkmalen des Anspruchs 1 und eines elektrischen Bearbeitungsgeräts mit den Merkmalen des Anspruchs 14. Vorteilhafte Weiterbildungen und/oder Ausgestaltungen der Erfindung sind in den abhängigen Ansprüchen beschrieben.

Das erfindungsgemäße Verfahren ist zum, insbesondere automatischen, Betreiben eines elektrischen Bearbeitungsgeräts ausgebildet bzw. konfiguriert. Das Bearbeitungsgerät weist einen benutzerbetätigbaren Bedienschalter, eine Motorelektronik aufweisend eine, insbesondere elektrische, Motoransteuerung und einen Elektroantriebsmotor auf. Der Bedienschalter ist eingangsseitig mit einer, insbesondere elektrischen, Antriebsspannungsquelle und ausgangsseitig mit der Motorelektronik elektrisch verbunden bzw. seriell geschaltet. Der Bedienschalter ist dazu ausgebildet, in einem geschlossenen Schaltzustand eine elektrische Verbindung zwischen der Antriebsspannungsquelle und der Motorelektronik herzustellen und in einem offenen Schaltzustand zu trennen. Der Bedienschalter ist ein trennender Schalter. Die Motorelektronik ist ausgangsseitig mittels der Motoransteuerung mit dem Elektroantriebsmotor elektrisch verbunden bzw. seriell geschaltet. Das Verfahren weist die Schritte auf: a) Überwachen, insbesondere automatisches Überwachen, ob eine Eingangsspannung an der Motorelektronik, insbesondere entweder, ein Geschlossen-Kriterium oder ein Offen-Kriterium erfüllt. Das Geschlossen-Kriterium ist für den geschlossenen Schaltzustand des Bedienschalters charakteristisch. Das Offen-Kriterium ist für den offenen Schaltzustand des Bedienschalters charakteristisch. b) falls das Offen-Kriterium erfüllt ist, Betreiben, insbesondere automatisches Betreiben, der Motoransteuerung in einem Zustand bzw. Modus aus einer Offen-Zustands-Menge bzw. Offen-Modus-Menge. Die Offen-Zustands-Menge weist einen Spannungssteuerungs-Zustand bzw. Spannungssteuerungs-Modus zum, insbesondere automatischen, Begrenzen eines Anstiegs der Eingangsspannung verursacht durch den auslaufenden bzw. austrudelnden Elektroantriebsmotor auf, insbesondere bei offenem Schaltzustand des Bedienschalters. Durch das Verwenden der Motoransteuerung als Aufwärtswandler und das Nutzen einer induzierten Ausgangsspannung des auslaufenden Elektroantriebsmotors wird die Eingangsspannung auf einem Spannungswert gehalten.

Dies, insbesondere der Spannungssteuerungs-Zustand, ermöglicht, unerwünschte Effekte zu vermeiden, insbesondere in Abhängigkeit eines fälschlicherweise Erfüllens des Geschlossen-Kriteriums, obwohl der Bedienschalter den offenen Schaltzustand aufweisen kann.

Insbesondere kann das Bearbeitungsgerät ein handgeführtes, insbesondere bodengeführtes oder handgetragenes, Bearbeitungsgerät sein. Insbesondere handgeführtes, insbesondere handgetragenes, Bearbeitungsgerät kann bedeuten, dass das Bearbeitungsgerät eine maximale Masse von 50 Kilogramm (kg), insbesondere von 20 kg, insbesondere von 10 kg, aufweisen kann. Zusätzlich oder alternativ kann das Bearbeitungsgerät ein Garten-, Forst- und/oder Baubearbeitungsgerät sein. Insbesondere kann das Bearbeitungsgerät eine Säge, ein Hoch-Entaster, ein Freischneider, eine Heckenschere, ein Heckenschneider, ein Blasgerät, ein Laubbläser, eine Astschere, ein Trennschleifer, ein Kehrgerät, eine Kehrwalze, eine Kehrbürste, ein Rasenmäher, ein Vertikutierer oder eine Grasschere sein. Weiter zusätzlich oder alternativ kann der Elektroantriebsmotor zum Antreiben eines Bearbeitungswerkzeugs des Bearbeitungsgeräts ausgebildet sein.

Weiter zusätzlich oder alternativ kann das Bearbeitungsgerät derart ausgebildet sein, dass der Bedienschalter durch einen Benutzer unmittelbar oder mittelbar betätigbar sein kann. Weiter zusätzlich oder alternativ kann der Bedienschalter ein in den offenen Schaltzustand selbstrückstellender Bedienschalter sein.

Die Motorelektronik kann eine Motorelektronik-Leiterplatte aufweisen.

Die Motoransteuerung kann als Endstufe bezeichnet werden.

Das Überwachen kann ein Messen der Eingangsspannung aufweisen.

Das Geschlossen-Kriterium und das Offen-Kriterium können verschieden sein.

Der Schritt a) kann andauernd ausgeführt werden. Zusätzlich oder alternativ kann der Schritt b) zeitgleich und/oder zeitlich nach dem Schritt a) ausgeführt werden. Weiter zusätzlich oder alternativ kann der Schritt b) ausgeführt werden, bis das Geschlossen-Kriterium erfüllt sein kann.

Der Zustand aus der Offen-Zustands-Menge, insbesondere der Spannungssteuerungs-Zustand, braucht oder kann kein Versorgen des Elektroantriebsmotors mit elektrischer Ausgangsleistung von der Antriebsspannungsquelle zu ermöglichen.

In einer Weiterbildung der Erfindung weist der Elektroantriebsmotor einen mechanischen Kommutator auf. Insbesondere ist der Elektroantriebsmotor eine Gleichstrommaschine. Somit kann der Elektroantriebsmotor und somit das Bearbeitungsgerät relativ kostengünstig sein. Insbesondere kann der mechanische Kommutator beim Auslaufen des Elektroantriebsmotors Kommutierungspeaks bzw. hohe Kommutierungsimpulse bzw. Abrissfunken verursachen, wobei die Kommutierungspeaks den Anstieg der Eingangsspannung verursachen können. Insbesondere können Bürsten des Kommutators jeweils für kurze Zeit zwei Lamellen des Kommutators berühren und somit die Abrissfunken verursachen.

In einer Weiterbildung der Erfindung ist das Geschlossen-Kriterium, dass die Eingangsspannung gleich oder größer als ein erster Spannungsgrenzwert ist und/oder ein, insbesondere zeitlicher, Anstieg der Eingangsspannung gleich oder größer als ein, insbesondere zeitlicher, Spannungsanstiegsgrenzwert ist.

Zusätzlich oder alternativ ist das Offen-Kriterium, dass die Eingangsspannung gleich oder kleiner als ein zweiter Spannungsgrenzwert ist und/oder ein, insbesondere zeitlicher, Abfall der Eingangsspannung gleich oder kleiner als ein, insbesondere zeitlicher, Spannungsabfallgrenzwert ist.

Der Spannungssteuerungs-Zustand ermöglicht ein fälschlicherweise Erfüllen des Geschlossen-Kriteriums, obwohl der Bedienschalter den offenen Schaltzustand aufweisen kann, zu vermeiden. In anderen Worten: Der Spannungssteuerungs-Zustand ermöglicht, dass das Überwachen, ob die Eingangsspannung das Geschlossen-Kriterium, insbesondere oder das Offen-Kriterium, erfüllt, funktionieren kann. Insbesondere kann das Überwachen ein Vergleichen der Eingangsspannung mit dem ersten Spannungsgrenzwert und/oder dem zweiten Spannungsgrenzwert aufweisen.

In einer Weiterbildung, insbesondere einer Ausgestaltung, der Erfindung weist das Bearbeitungsgerät einen Leistungspfad und einen von dem Leistungspfad verschiedenen Informationspfad auf. Der Leistungspfad verbindet elektrisch die Antriebsspannungsquelle mit der Motorelektronik eingangsseitig für einen Fluss von elektrischer Antriebsleistung von der Antriebsspannungsquelle zu der Motorelektronik, insbesondere im geschlossenen Schaltzustand des Bedienschalters. Der Bedienschalter ist in dem Leistungspfad elektrisch angeordnet bzw. seriell geschaltet. Der Informationspfad verbindet elektrisch, insbesondere andauernd, die Antriebspannungsquelle mit der Motorelektronik für eine Information über einen Spannungsquellenwert der Antriebspannungsquelle. Das Verfahren weist den Schritt auf: Vorgeben, insbesondere automatisches Vorgeben, des Geschlossen-Kriteriums, insbesondere des ersten Spannungsgrenzwerts und/oder des Spannungsanstiegsgrenzwerts, soweit vorhanden, und/oder des Offen-Kriteriums, insbesondere des zweiten Spannungsgrenzwerts und/oder des Spannungsabfallgrenzwerts, soweit vorhanden, in Abhängigkeit der bereitgestellten Information über den Spannungsquellenwert. Dies ermöglicht das Geschlossen-Kriterium und/oder das Offen-Kriterium an den Spannungsquellenwert aktuell anzupassen. Insbesondere kann die Antriebspannungsquelle einen Akkumulator aufweisen. Der Spannungsquellenwert kann mit zunehmender Entladung des Akkumulators abfallen. Zusätzlich oder alternativ kann die Information der Spannungsquellenwert sein. Weiter zusätzlich oder alternativ braucht oder kann der Informationspfad die Antriebsspannungsquelle mit der Motorelektronik nicht für einen Fluss von elektrischer Antriebsleistung von der Antriebsspannungsquelle zu der Motorelektronik elektrisch verbinden. Weiter zusätzlich oder alternativ kann der Informationspfad als Bypassleitung bezeichnet werden. Weiter zusätzlich oder alternativ braucht oder kann der Bedienschalter nicht in dem Informationspfad elektrisch angeordnet sein. Weiter zusätzlich oder alternativ kann der Leistungspfad als Powerleitung bezeichnet werden. Weiter zusätzlich oder alternativ kann das Überwachen ein Messen des Spannungsquellenwerts und/oder ein Vergleichen der Eingangsspannung mit dem Spannungsquellenwert aufweisen.

In einer Ausgestaltung der Erfindung ist der zweite Spannungsgrenzwert kleiner als der erste Spannungsgrenzwert. Insbesondere ist der zweite Spannungsgrenzwert mindestens 0,75 Volt (V), insbesondere 1,5 V, kleiner als der erste Spannungsgrenzwert. Zusätzlich oder alternativ liegt der zweite Spannungsgrenzwert in einem Bereich von 0,8-mal bis 0,9-mal des ersten Spannungsgrenzwerts.

Zusätzlich oder alternativ ist der erste Spannungsgrenzwert kleiner als der Spannungsquellenwert. Insbesondere ist der erste Spannungsgrenzwert mindestens 0,25 V, insbesondere 0,5 V, kleiner als der Spannungsquellenwert. Weiter zusätzlich oder alternativ liegt der erste Spannungsgrenzwert in einem Bereich von 0,85-mal bis 0,95-mal des Spannungsquellenwerts.

Weiter zusätzlich oder alternativ liegt der erste Spannungsgrenzwert in einem Bereich von 7,5 V bis 20,5 V, insbesondere bis 11,5 V.

Weiter zusätzlich oder alternativ liegt der zweite Spannungsgrenzwert in einem Bereich von 6 V, insbesondere von 7,5 V, bis 20,5 V, insbesondere bis 10 V.

Weiter zusätzlich oder alternativ liegt der Spannungsquellenwert in einem Bereich von 8 V bis 20,5 V, insbesondere bis 12 V.

Bei diesen niedrigen Spannungswerten braucht oder kann das Überwachen, ob die Eingangsspannung das Geschlossen-Kriterium, insbesondere oder das Offen-Kriterium, erfüllt, ohne den erfindungsgemäßen Spannungssteuerungs-Zustand nicht zu funktionieren, insbesondere im Unterschied zu hohen Spannungswerten, wie z.B. 36 V. Insbesondere kann sich bei diesen niedrigen Spannungswerten die Eingangsspannung ohne den erfindungsgemäßen Spannungssteuerungs-Zustand lange ungefähr auf dem Level der Antriebsspannung bzw. des Spannungsqellenwerts halten. Dadurch braucht oder kann in diesem Bereich kein schneller Spannungsanstieg bei erneuter Betätigung des Bedienschalters erkannt werden. D.h. in einem größeren Zeitraum braucht oder kann damit keine Schaltererkennung bzw. Erkennung des Schaltzustands möglich sein. Insbesondere kann eine Nennspannung der Antriebsspannungsquelle 10,8 V oder 18 V sein.

In einer Weiterbildung der Erfindung weist das Verfahren den Schritt auf: c) falls das Geschlossen-Kriterium erfüllt ist, Betreiben, insbesondere automatisches Betreiben, der Motoransteuerung in einem Aktiv-Zustand bzw. Aktiv-Modus zum, insbesondere automatischen, Versorgen des Elektroantriebsmotors mit elektrischer Ausgangsleistung von der Antriebsspannungsquelle, insbesondere bei geschlossenem Schaltzustand des Bedienschalters. Dies, insbesondere der Aktiv-Zustand, ermöglicht das Laufen des Elektroantriebsmotors, insbesondere bei geschlossenem Schaltzustand des Bedienschalters. Insbesondere kann der Schritt c) zeitlich vor und/oder nach dem Schritt b) ausgeführt werden. Zusätzlich oder alternativ kann entweder der Schritt c) oder der Schritt b) ausgeführt werden. Weiter zusätzlich oder alternativ kann der Schritt c) zeitgleich und/oder zeitlich nach dem Schritt a) ausgeführt werden. Weiter zusätzlich oder alternativ kann der Schritt c) ausgeführt werden, bis das Offen-Kriterium erfüllt sein kann. Weiter zusätzlich oder alternativ kann der Aktiv-Zustand bei offenem Schaltzustand des Bedienschalters den Abfall der Eingangsspannung und somit ein Erfüllen des Offen-Kriteriums ermöglichen, insbesondere verursachen. Weiter zusätzlich oder alternativ braucht oder kann der Aktiv-Zustand nicht aus der Offen-Zustands-Menge sein. Insbesondere kann der Aktiv-Zustand von dem Spannungssteuerungs-Zustand verschieden sein. Weiter zusätzlich oder alternativ kann der Schritt c) aufweisen: Betreiben der Motoransteuerung in dem Aktiv-Zustand zum, insbesondere automatischen, Halten einer Ausgangsspannung an der Motorelektronik, insbesondere der Motoransteuerung, bzw. dem Elektroantriebsmotor auf einem, insbesondere konstanten, Spannungswert, insbesondere mit elektrischer Ausgangsleistung von der Antriebsspannungsquelle und/oder bei geschlossenem Schaltzustand des Bedienschalters. Insbesondere kann der Spannungswert der Ausgangsspannung in Abhängigkeit der bereitgestellten Information über den Spannungsquellenwert und/oder einer Information über den Elektroantriebsmotor vorgegeben werden oder sein.

In einer Weiterbildung der Erfindung weist die Offen-Zustands-Menge den Spannungssteuerungs-Zustand zum, insbesondere automatischen, Zulassen eines Anstiegs der Eingangsspannung verursacht durch die Antriebsspannungsquelle bei geschlossenem Schaltzustand des Bedienschalters auf. Dies, insbesondere der Spannungssteuerungs-Zustand, ermöglicht bei geschlossenem Schaltzustand des Bedienschalters ein Erfüllen des Geschlossen-Kriteriums. Somit ermöglicht dies, dass das Überwachen, ob die Eingangsspannung das Geschlossen-Kriterium, insbesondere oder das Offen-Kriterium, erfüllt, funktionieren kann.

In einer Weiterbildung der Erfindung weist die Offen-Zustands-Menge den Spannungssteuerungs-Zustand zum, insbesondere automatischen, Halten der Eingangsspannung auf einem, insbesondere dem und/oder konstanten, Spannungswert, insbesondere dem zweiten Spannungsgrenzwert, auf, insbesondere bei offenem Schaltzustand des Bedienschalters. Dies ermöglicht einen weiteren Abfall der Eingangsspannung zunächst zu vermeiden. Somit ermöglicht dies bei erneuter Betätigung bzw. geschlossenem Schaltzustand des Bedienschalters einen Einschaltstrom niedrig zu halten. Somit ermöglicht dies eine Beschädigung der Motorelektronik zu vermeiden. Insbesondere kann der Spannungswert, insbesondere der zweite Spannungsgrenzwert, in einem Bereich wie zuvor beschrieben liegen. Zusätzlich oder alternativ kann auf dem Spannungswert halten bedeuten, dass die Eingangsspannung in einem engen Bereich, z.B. plus/minus 0,25V, um den Spannungswert gehalten werden kann.

In einer Weiterbildung der Erfindung weist die Offen-Zustands-Menge einen von dem Spannungssteuerungs-Zustand verschiedenen Inaktiv-Zustand bzw. Inaktiv-Modus zum, insbesondere automatischen, Nicht-Begrenzen eines Anstiegs der Eingangsspannung verursacht durch den auslaufenden Elektroantriebsmotor auf, insbesondere bei offenem Schaltzustand des Bedienschalters. Der Schritt b) weist auf: zeitlich nach dem Betreiben der Motoransteuerung in dem Spannungssteuerungs-Zustand, insbesondere automatisches, Betreiben der Motoransteuerung in dem Inaktiv-Zustand. Insbesondere kann das Betreiben in dem Inaktiv-Zustand ein Nicht-Betreiben sein. Zusätzlich oder alternativ kann der Schritt b) aufweisen, Betreiben der Motoransteuerung in dem Inaktiv-Zustand, falls die Eingangsspannung nicht mehr auf dem Spannungswert gehalten werden kann, soweit vorhanden, und/oder falls der auslaufende oder sogar ausgelaufene Elektroantriebsmotor keinen hohen oder sogar gar keinen Anstieg der Eingangsspannung verursachen kann. Weiter zusätzlich oder alternativ kann der Inaktiv-Zustand von dem Aktiv-Zustand verschieden sein.

In einer Weiterbildung der Erfindung weist die Motoransteuerung mindestens ein, insbesondere erstes, Motorschaltelement und mindestens ein, insbesondere erstes, Schutzelement, insbesondere eine Schutzdiode, zum Schutz des Motorschaltelements, insbesondere vor einer Beschädigung verursacht durch den auslaufenden Elektroantriebsmotor, auf. Das Schutzelement ermöglicht einen Anstieg der Eingangsspannung verursacht durch den auslaufenden Elektroantriebsmotor. Insbesondere kann das Schutzelement antiparallel zu dem Motorschaltelement elektrisch angeordnet bzw. geschaltet sein. Zusätzlich oder alternativ kann die Schutzdiode als Freilaufdiode oder Body-Diode bezeichnet werden. Weiter zusätzlich oder alternativ kann das Motorschaltelement ein Transistor sein.

In einer Weiterbildung, insbesondere Ausgestaltung, der Erfindung weist die Motoransteuerung ein, insbesondere das, ansteuerbares erstes Motorschaltelement und/oder ein ansteuerbares zweites Motorschaltelement auf. Das erste Motorschaltelement ist nach dem Bedienschalter und vor dem Elektroantriebsmotor elektrisch angeordnet bzw. seriell geschaltet. Das zweite Motorschaltelement ist parallel zu dem Elektroantriebsmotor elektrisch angeordnet bzw. geschaltet.

Das Betreiben der Motoransteuerung in dem Aktiv-Zustand, soweit vorhanden, weist auf: Steuern, insbesondere automatisches Steuern, des ersten Motorschaltelements abwechselnd in einen An-Zustand und in einen Aus-Zustand, insbesondere mittels Pulsweitenmodulation. Zusätzlich oder alternativ weist das Betreiben der Motoransteuerung in dem Spannungssteuerungs-Zustand auf: Steuern, insbesondere automatisches Steuern, des ersten Motorschaltelements abwechselnd in den An-Zustand und in den Aus-Zustand, insbesondere mittels Pulsweitenmodulation. Weiter zusätzlich oder alternativ weist das Betreiben der Motoransteuerung in dem Inaktiv-Zustand auf: Steuern, insbesondere automatisches Steuern, des ersten Motorschaltelements andauernd in den Aus-Zustand.

Zusätzlich oder alternativ weist das Betreiben der Motoransteuerung in dem Aktiv-Zustand auf: Steuern, insbesondere automatisches Steuern, des zweiten Motorschaltelements abwechselnd in einen An-Zustand und in einen Aus-Zustand, insbesondere mittels Pulsweitenmodulation. Zusätzlich oder alternativ weist das Betreiben der Motoransteuerung in dem Spannungssteuerungs-Zustand auf: Steuern, insbesondere automatisches Steuern, des zweiten Motorschaltelements abwechselnd in den An-Zustand und in den Aus-Zustand, insbesondere mittels Pulsweitenmodulation. Weiter zusätzlich oder alternativ weist das Betreiben der Motoransteuerung in dem Inaktiv-Zustand auf: Steuern, insbesondere automatisches Steuern, des zweiten Motorschaltelements andauernd in den Aus-Zustand.

Das Steuern in dem Aktiv-Zustand ermöglicht bei geschlossenem Schaltzustand des Bedienschalters das Versorgen des Elektroantriebsmotors mit elektrischer Ausgangsleistung von der Antriebsspannungsquelle und/oder bei offenem Schaltzustand des Bedienschalters den Abfall der Eingangsspannung.

Zusätzlich oder alternativ ermöglicht das Steuern in dem Spannungssteuerungs-Zustand bei offenem Schaltzustand des Bedienschalters das Begrenzen des Anstiegs der Eingangsspannung, insbesondere das Halten der Eingangsspannung, und/oder bei geschlossenem Schaltzustand des Bedienschalters das Zulassen des Anstiegs der Eingangsspannung.

Weiter zusätzlich oder alternativ ermöglicht das Steuern in dem Inaktiv-Zustand, insbesondere bei offenem Schaltzustand des Bedienschalters, das Nicht-Begrenzen des Anstiegs der Eingangsspannung.

Insbesondere können das erste Motorschaltelement und das zweite Motorschaltelement als Spannungssteuerer, insbesondere als Spannungsregler, betrieben werden. Zusätzlich oder alternativ können das erste Motorschaltelement und das zweite Motorschaltelement verschieden sein. Weiter zusätzlich oder alternativ kann das erste Motorschaltelement als Highside-Schaltelement bezeichnet werden und/oder das zweite Motorschaltelement kann als Lowside-Schaltelement bezeichnet werden. Weiter zusätzlich oder alternativ können/kann das zweite Motorschaltelement und/oder der Elektroantriebsmotor jeweils nach dem ersten Motorschaltelement und vor Masse elektrisch angeordnet bzw. seriell geschaltet sein. Weiter zusätzlich oder alternativ können das erste Motorschaltelement und das zweite Motorschaltelement jeweils ein Transistor sein. Weiter zusätzlich oder alternativ können der An-Zustand und der Aus-Zustand verschieden sein. Weiter zusätzlich oder alternativ kann der An-Zustand als leitender bezeichnet werden und/oder der Aus-Zustand kann als nicht-leitender bzw. trennender Zustand bezeichnet werden. Weiter zusätzlich oder alternativ kann andauernd als permanent bezeichnet werden und/oder in den einen Zustand und nicht in den anderen Zustand bedeuten. Weiter zusätzlich oder alternativ kann das Betreiben der Motoransteuerung in dem Aktiv-Zustand und/oder in dem Spannungssteuerungs-Zustand aufweisen: Steuern des ersten Motorschaltelement und des zweiten Motorschaltelements mittels komplementärer Pulsweitenmodulation,

In einer Weiterbildung der Erfindung weist die Motorelektronik mindestens einen Zwischenkreiskondensator auf. Die Eingangsspannung ist eine Zwischenkreisspannung des mindestens einen Zwischenkreiskondensators. Insbesondere kann der Zwischenkreiskondensator nach dem Bedienschalter und vor dem, insbesondere ersten, Motorschaltelement und/oder vor dem Schutzelement und/oder vor Masse elektrisch angeordnet bzw. seriell geschaltet sein. Zusätzlich oder alternativ können der Zwischenkreiskondensator, die Schutzdiode, das zweite Motorschaltelement, insbesondere das erste Motorschaltelement, und der Elektroantriebsmotor einen, insbesondere den, Aufwärtswandler bzw. einen Boost Converter, insbesondere mindestens teilweise oder sogar vollständig, bilden.

In einer Weiterbildung der Erfindung weist das Verfahren den Schritt auf: falls das Geschlossen-Kriterium erfüllt ist, Ausführen, insbesondere automatisches Ausführen, eines Selbsttests des Bearbeitungsgeräts und/oder Ausgeben, insbesondere automatisches Ausgeben, einer benutzerwahrnehmbaren Information, insbesondere in Abhängigkeit eines Ergebnis des Selbsttests. Der Spannungssteuerungs-Zustand ermöglicht, dass das Ausführen des Selbsttests und/oder das Ausgeben nur dann erfolgen/erfolgt, falls der Bedienschalter den geschlossenen Schaltzustand aufweist. Somit ermöglicht dies, insbesondere der Spannungssteuerungs-Zustand, unerwünschte Effekte zu vermeiden, insbesondere in Abhängigkeit eines fälschlicherweise Erfüllens des Geschlossen-Kriteriums, obwohl der Bedienschalter den offenen Schaltzustand aufweisen kann. Insbesondere könnte ein unerwünschter Effekt sein, dass ein Ergebnis des Selbsttests ist, dass das Geschlossen-Kriterium erfüllt ist, obwohl der Bedienschalter den offenen Schaltzustand aufweist, und somit als Fehler erkannt ist, und dass dieser Fehler ausgegeben wird. Zusätzlich oder alternativ kann das Ausgeben ein optisches und/oder akustisches Ausgeben sein.

Das erfindungsgemäße elektrische Bearbeitungsgerät weist einen, insbesondere den, benutzerbetätigbaren Bedienschalter, eine, insbesondere die, Motorelektronik aufweisend eine, insbesondere die, Motoransteuerung und aufweisend eine, insbesondere elektrische, Überwachungs- und Steuerungseinrichtung und einen, insbesondere den, Elektroantriebsmotor auf. Der Bedienschalter ist eingangsseitig zum elektrischen Verbinden mit einer, insbesondere der, Antriebsspannungsquelle ausgebildet und ausgangsseitig mit der Motorelektronik elektrisch verbunden. Der Bedienschalter ist dazu ausgebildet, in einem, insbesondere dem, geschlossenen Schaltzustand eine, insbesondere die, elektrische Verbindung zwischen der Antriebsspannungsquelle und der Motorelektronik herzustellen und in einem, insbesondere dem, offenen Schaltzustand zu trennen. Der Bedienschalter ist ein, insbesondere der, trennender Schalter. Die Motorelektronik ist ausgangsseitig mittels der Motoransteuerung mit dem Elektroantriebsmotor elektrisch verbunden. Die Überwachungs- und Steuerungseinrichtung ist zum, insbesondere automatischen, Überwachen, ob eine, insbesondere die, Eingangsspannung an der Motorelektronik, insbesondere entweder, ein, insbesondere das, Geschlossen-Kriterium oder ein, insbesondere das, Offen-Kriterium erfüllt, ausgebildet bzw. konfiguriert. Das Geschlossen-Kriterium ist für den geschlossenen Schaltzustand des Bedienschalters charakteristisch. Das Offen-Kriterium ist für den offenen Schaltzustand des Bedienschalters charakteristisch. Des Weiteren ist die Überwachungs- und Steuerungseinrichtung, falls das Offen-Kriterium erfüllt ist, zum, insbesondere automatischen, Betreiben der Motoransteuerung in einem, insbesondere dem, Zustand aus einer, insbesondere der, Offen-Zustands-Menge ausgebildet bzw. konfiguriert. Die Offen-Zustands-Menge weist einen, insbesondere den, Spannungssteuerungs-Zustand zum, insbesondere automatischen, Begrenzen eines, insbesondere des, Anstiegs der Eingangsspannung verursacht durch den auslaufenden Elektroantriebsmotor auf. Die Überwachungs- und Steuerungseinrichtung ist dazu ausgebildet, dass durch das Verwenden der Motoransteuerung als Aufwärtswandler und das Nutzen einer, insbesondere der, induzierten Ausgangsspannung des auslaufenden Elektroantriebsmotors die Eingangsspannung auf einem, insbesondere dem, Spannungswert gehalten wird.

Das Bearbeitungsgerät kann den/die gleichen Vorteil/e wie für das Verfahren zuvor beschrieben ermöglichen.

Insbesondere kann das Bearbeitungsgerät, insbesondere die Überwachungs- und Steuerungseinrichtung, zum Ausführen eines Verfahrens wie zuvor beschrieben ausgebildet bzw. konfiguriert sein. Zusätzlich oder alternativ kann das Bearbeitungsgerät wie zuvor für das Verfahren beschrieben ausgebildet bzw. konfiguriert sein. Weiter zusätzlich oder alternativ kann die Überwachungs- und Steuerungseinrichtung einen Mikrocontroller aufweisen, insbesondere sein. Weiter zusätzlich oder alternativ kann das Bearbeitungsgerät zum Tragen, insbesondere zum, insbesondere auswechselbaren, Aufnehmen, der Antriebsspannungsquelle aufweisend den Akkumulator ausgebildet sein.

In einer Weiterbildung der Erfindung weist das Bearbeitungsgerät die Antriebsspannungsquelle auf. Insbesondere weist die Antriebsspannungsquelle einen, insbesondere den, Akkumulator auf. Insbesondere ist der Bedienschalter eingangsseitig mit der Antriebsspannungsquelle elektrisch verbunden. Zusätzlich oder alternativ kann die Antriebsspannungsquelle als eine auswechselbare Antriebsspannungsquelle ausgebildet sein.

### KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind. Dabei zeigen:
- Fig. 1: eine schematische Ansicht eines erfindungsgemäßen elektrischen Bearbeitungsgeräts,
- Fig. 2: ein Ersatzschaltbild des Bearbeitungsgeräts der Fig. 1,
- Fig. 3: ein detailliertes Ersatzschaltschild eines Ausschnitts des Bearbeitungsgeräts der Fig. 1,
- Fig. 4: ein Schaltschema des Bearbeitungsgeräts der Fig. 1,
- Fig. 5: einen Graphen einer Ausgangsspannung eines, insbesondere auslaufenden, Elektroantriebsmotors des Bearbeitungsgeräts der Fig. 1 über der Zeit,
- Fig. 6: ein Ablaufdiagramm, insbesondere einen Graphen einer Schaltzustands eines benutzerbetätigbaren Bedienschalters und einer Eingangsspannung an einer Motorelektronik über der Zeit, eines nicht erfindungsgemäßen Verfahrens,
- Fig. 7: ein weiteres Ablaufdiagramm eines weiteren nicht erfindungsgemäßen Verfahrens, und
- Fig. 8: ein Ablaufdiagramm, insbesondere einen Graphen einer Schaltzustands eines benutzerbetätigbaren Bedienschalters des Bearbeitungsgeräts der Fig. 1 und einer Eingangsspannung an einer Motorelektronik des Bearbeitungsgeräts der Fig. 1 über der Zeit, eines erfindungsgemäßen Verfahrens.

### DETAILLIERTE BESCHREIBUNG DER AUSFÜHRUNGSBEISPIELE

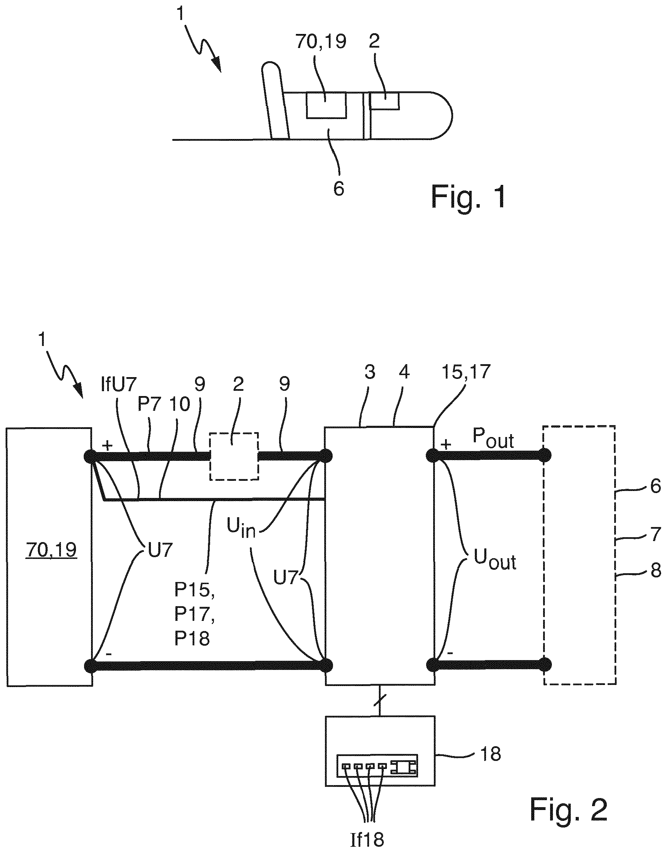

Fig. 1 bis 4 zeigen ein erfindungsgemäßes elektrisches Bearbeitungsgerät 1. Das Bearbeitungsgerät 1 weist einen benutzerbetätigbaren Bedienschalter 2, eine Motorelektronik 3 aufweisend eine Motoransteuerung 4 und aufweisend eine Überwachungs- und Steuerungseinrichtung 15 und einen Elektroantriebsmotor 6 auf. Der Bedienschalter 2 ist eingangsseitig zum elektrischen Verbinden mit einer Antriebsspannungsquelle 70 ausgebildet und ausgangsseitig mit der Motorelektronik 3 elektrisch verbunden. Die Motorelektronik 3 ist ausgangsseitig mittels der Motoransteuerung 4 mit dem Elektroantriebsmotor 6 elektrisch verbunden. Die Überwachungs- und Steuerungseinrichtung 15 ist zum Überwachen, ob eine Eingangsspannung Uin an der Motorelektronik 3 ein Geschlossen-Kriterium ck oder ein Offen-Kriterium ok erfüllt, ausgebildet. Das Geschlossen-Kriterium ck ist für einen geschlossenen Schaltzustand closed des Bedienschalters 2 charakteristisch. Das Offen-Kriterium ok ist für einen offenen Schaltzustand open des Bedienschalters 2 charakteristisch. Des Weiteren ist die Überwachungs- und Steuerungseinrichtung 15, falls das Offen-Kriterium ok erfüllt ist, zum Betreiben der Motoransteuerung 4 in einem Zustand SZ, IZ aus einer Offen-Zustands-Menge ausgebildet. Die Offen-Zustands-Menge weist einen Spannungssteuerungs-Zustand SZ zum Begrenzen eines Anstiegs der Eingangsspannung Uin verursacht durch den auslaufenden Elektroantriebsmotor 6 auf, insbesondere bei offenem Schaltzustand open des Bedienschalters 2.

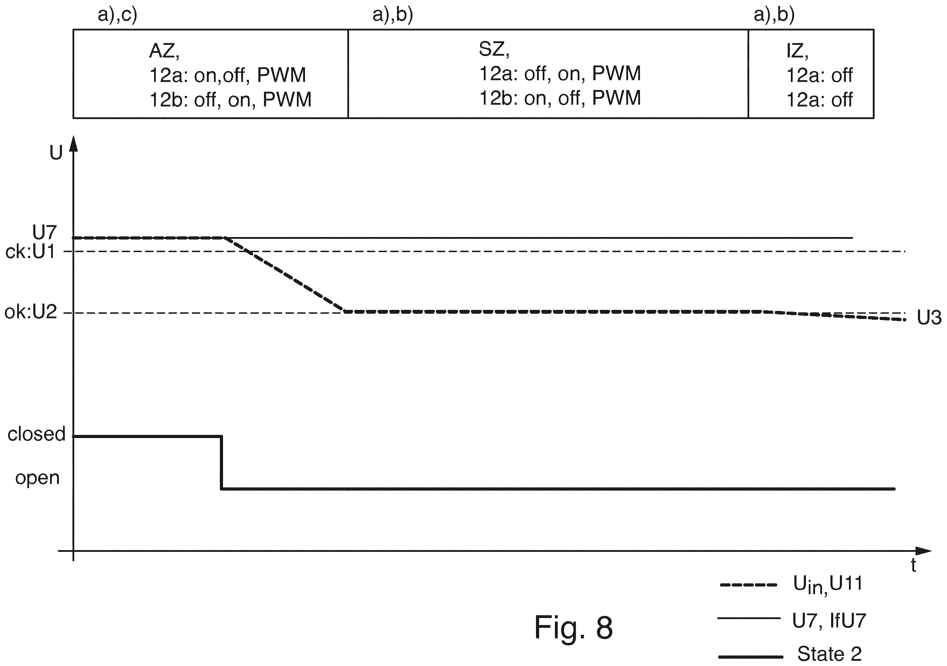

Fig. 8 zeigt ein erfindungsgemäßes Verfahren zum Betreiben des elektrischen Bearbeitungsgeräts 1, insbesondere mittels der Überwachungs- und Steuerungseinrichtung 15. Das Bearbeitungsgerät 1 weist den benutzerbetätigbaren Bedienschalter 2, die Motorelektronik 3 aufweisend die Motoransteuerung 4 und den Elektroantriebsmotor 6 auf. Der Bedienschalter 2 ist eingangsseitig mit der Antriebsspannungsquelle 7 und ausgangsseitig mit der Motorelektronik 3 elektrisch verbunden. Die Motorelektronik 3 ist ausgangsseitig mittels der Motoransteuerung 4 mit dem Elektroantriebsmotor 6 elektrisch verbunden. Das Verfahren weist die Schritte auf: a) Überwachen, ob die Eingangsspannung Uin an der Motorelektronik 3 das Geschlossen-Kriterium ck oder das Offen-Kriterium ok erfüllt, insbesondere mittels der Überwachungs- und Steuerungseinrichtung 15. Das Geschlossen-Kriterium ck ist für den geschlossenen Schaltzustand closed des Bedienschalters 2 charakteristisch. Das Offen-Kriterium ok ist für den offenen Schaltzustand open des Bedienschalters 2 charakteristisch. b) falls das Offen-Kriterium erfüllt ist, Betreiben der Motoransteuerung 4 in dem Zustand SZ, IZ aus der Offen-Zustands-Menge, insbesondere mittels der Überwachungs- und Steuerungseinrichtung 15. Die Offen-Zustands-Menge weist den Spannungssteuerungs-Zustand SZ zum Begrenzen des Anstiegs der Eingangsspannung Uin verursacht durch den auslaufenden Elektroantriebsmotor 6 auf.

Im Detail weist das Bearbeitungsgerät 1 die Antriebsspannungsquelle 70 auf. Insbesondere weist die Antriebsspannungsquelle 70 einen Akkumulator 19 auf.

Außerdem ist im gezeigten Ausführungsbeispiel das Bearbeitungsgerät 1 eine Heckenschere. In alternativen Ausführungsbeispielen kann das Bearbeitungsgerät eine Säge, ein Hoch-Entaster, ein Freischneider, ein Heckenschneider, ein Blasgerät, ein Laubbläser, eine Astschere, ein Trennschleifer, ein Kehrgerät, eine Kehrwalze, eine Kehrbürste, ein Rasenmäher, ein Vertikutierer oder eine Grasschere sein.

Weiter weist der Elektroantriebsmotor 6 einen mechanischen Kommutator 7 auf. Insbesondere ist der Elektroantriebsmotor 6 eine Gleichstrommaschine 8.

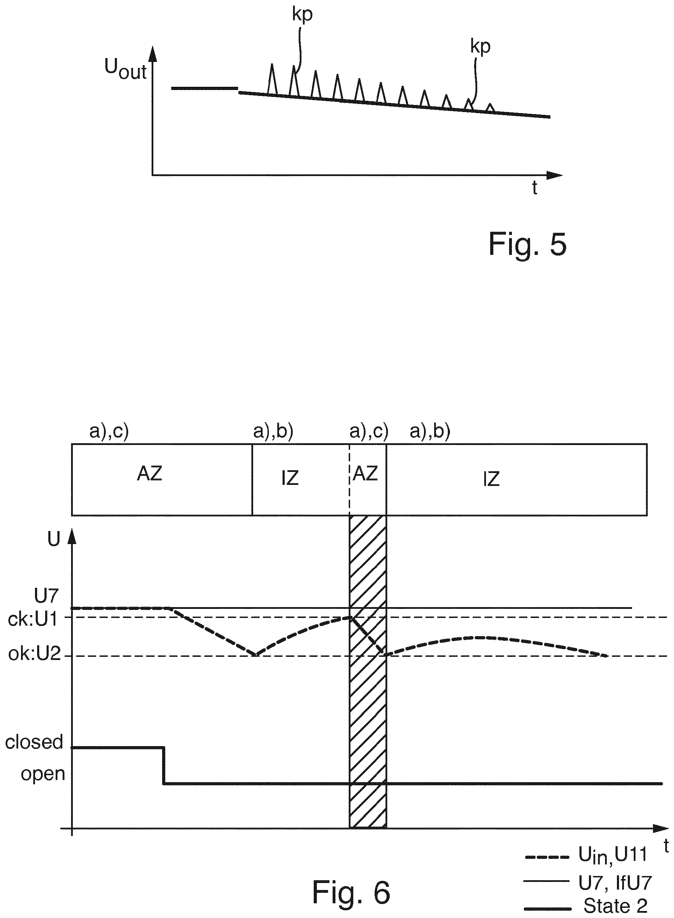

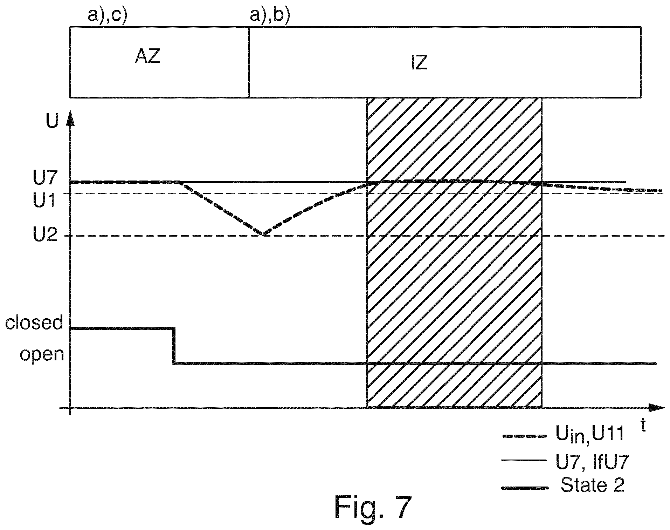

Im Detail verursacht der mechanische Kommutator 7 beim Auslaufen des Elektroantriebsmotors 6 Kommutierungspeaks KP, wie in Fig 5 gezeigt. Die Kommutierungspeaks KP können den Anstieg der Eingangsspannung Uin verursachen, wie in Fig. 6 und 7 gezeigt.

Zudem ist im gezeigten Ausführungsbeispiel das Geschlossen-Kriterium ck, dass die Eingangsspannung Uin gleich oder größer als ein erster Spannungsgrenzwert U1 ist. In alternativen Ausführungsbeispielen kann zusätzlich oder alternativ das Geschlossen-Kriterium sein, dass ein Anstieg der Eingangsspannung gleich oder größer als ein Spannungsanstiegsgrenzwert ist.

Zusätzlich ist im gezeigten Ausführungsbeispiel das Offen-Kriterium ok, dass die Eingangsspannung Uin gleich oder kleiner als ein zweiter Spannungsgrenzwert U2 ist. In alternativen Ausführungsbeispielen kann zusätzlich oder alternativ das Offen-Kriterium sein, dass ein Abfall der Eingangsspannung gleich oder kleiner als ein Spannungsabfallgrenzwert ist.

Der Spannungssteuerungs-Zustand SZ ermöglicht ein fälschlicherweise Erfüllen des Geschlossen-Kriteriums cK, wie in Fig. 6 zu Beginn des schraffierten Bereichs gezeigt, obwohl der Bedienschalter 2 den offenen Schaltzustand open aufweist, zu vermeiden, wie in Fig. 8 gezeigt.

Des Weiteren weist das Bearbeitungsgerät 2 einen Leistungspfad 9 und einen von dem Leistungspfad 9 verschiedenen Informationspfad 10 auf. Der Leistungspfad 9 verbindet elektrisch die Antriebsspannungsquelle 70 mit der Motorelektronik 3 eingangsseitig für einen Fluss von elektrischer Antriebsleistung P7 von der Antriebsspannungsquelle 70 zu der Motorelektronik 3, insbesondere im geschlossenen Schaltzustand closed des Bedienschalters 2. Der Bedienschalter 2 ist in dem Leistungspfad 9 elektrisch angeordnet. Der Informationspfad 10 verbindet elektrisch die Antriebspannungsquelle 70 mit der Motorelektronik 3, insbesondere der Überwachungs- und Steuerungseinrichtung 15, für eine Information IfU7 über einen Spannungsquellenwert U7 der Antriebspannungsquelle 70. Das Verfahren weist den Schritt auf: Vorgeben des Geschlossen-Kriteriums ck, im gezeigten Ausführungsbeispiel des ersten Spannungsgrenzwerts U1, und/oder des Offen-Kriteriums ok, im gezeigten Ausführungsbeispiel des zweiten Spannungsgrenzwerts U2, in Abhängigkeit der bereitgestellten Information IfU7 über den Spannungsquellenwert U7, insbesondere mittels der Überwachungs- und Steuerungseinrichtung 15.

Im gezeigten Ausführungsbeispiel verbindet elektrisch der Informationspfad 10 die Antriebsspannungsquelle 70 mit der Motorelektronik 3, insbesondere der Überwachungs- und Steuerungseinrichtung 15, für einen Fluss von elektrischer Leistung P15 von der Antriebsspannungsquelle 70 zu der Überwachungs- und Steuerungseinrichtung 15 für einen Betreib der Überwachungs- und Steuerungseinrichtung 15, insbesondere bei offenem Schaltzustand open des Bedienschalters 2.

Außerdem ist der zweite Spannungsgrenzwert U2 kleiner als der erste Spannungsgrenzwert U1. Insbesondere ist der zweite Spannungsgrenzwert U2 mindestens 0,75 V kleiner als der erste Spannungsgrenzwert U1. Zusätzlich oder alternativ liegt der zweite Spannungsgrenzwert U2 in einem Bereich von 0,8-mal bis 0,9-mal des ersten Spannungsgrenzwerts U1.

Zusätzlich ist der erste Spannungsgrenzwert U1 kleiner als der Spannungsquellenwert U7. Insbesondere ist der erste Spannungsgrenzwert U1 mindestens 0,25 V kleiner als der Spannungsquellenwert U7. Weiter zusätzlich oder alternativ liegt der erste Spannungsgrenzwert U1 in einem Bereich von 0,85-mal bis 0,95-mal des Spannungsquellenwerts U7.

Weiter zusätzlich liegt der erste Spannungsgrenzwert U1 in einem Bereich von 7,5 V bis 20,5 V.

Weiter zusätzlich liegt der zweite Spannungsgrenzwert U2 in einem Bereich von 6 V bis 20,5 V.

Weiter zusätzlich liegt der Spannungsquellenwert U7 in einem Bereich von 8 V bis 20,5 V.

Bei diesen niedrigen Spannungswerten braucht oder kann das Überwachen, ob die Eingangsspannung das Geschlossen-Kriterium erfüllt, insbesondere dass ein Anstieg der Eingangsspannung gleich oder größer als ein Spannungsanstiegsgrenzwert ist, ohne den erfindungsgemäßen Spannungssteuerungs-Zustand nicht zu funktionieren. Insbesondere kann bei diesen niedrigen Spannungswerten die Eingangsspannung sich ohne den erfindungsgemäßen Spannungssteuerungs-Zustand lange ungefähr auf dem Level der Antriebsspannung bzw. des Spannungsquellenwerts halten, wie in Fig. 7 gezeigt. Dadurch braucht oder kann in diesem, in Fig. 7 schraffierten, Bereich kein schneller Spannungsanstieg bei erneuter Betätigung des Bedienschalters erkannt werden. D.h. in einem größeren Zeitraum braucht oder kann damit keine Schaltererkennung bzw. Erkennung des Schaltzustands möglich sein.

Zudem weist das Verfahren den Schritt auf: c) falls das Geschlossen-Kriterium ck erfüllt ist, Betreiben der Motoransteuerung 4 in einem Aktiv-Zustand AZ zum Versorgen des Elektroantriebsmotors 6 mit elektrischer Ausgangsleistung Pout von der Antriebsspannungsquelle 70, insbesondere bei geschlossenem Schaltzustand closed des Bedienschalters 2, insbesondere mittels der Überwachungs- und Steuerungseinrichtung 15.

Im gezeigten Ausführungsbeispiel ermöglicht der Aktiv-Zustand AZ bei offenem Schaltzustand open des Bedienschalters 2 den Abfall der Eingangsspannung Uin und somit ein Erfüllen des Offen-Kriteriums ok.

Des Weiteren weist die Offen-Zustands-Menge den Spannungssteuerungs-Zustand SZ zum Zulassen eines Anstiegs der Eingangsspannung Uin verursacht durch die Antriebsspannungsquelle 70 bei geschlossenem Schaltzustand closed des Bedienschalters 2 auf.

Der Spannungssteuerungs-Zustand SZ ermöglicht bei geschlossenem Schaltzustand closed des Bedienschalters 2 ein Erfüllen des Geschlossen-Kriteriums ck.

Außerdem weist die Offen-Zustands-Menge den Spannungssteuerungs-Zustand SZ zum Halten der Eingangsspannung Uin auf einem Spannungswert U3, im gezeigten Ausführungsbeispiel dem zweiten Spannungsgrenzwert U2, auf, insbesondere bei offenem Schaltzustand open des Bedienschalters 2.

Der Spannungssteuerungs-Zustand SZ ermöglicht einen weiteren Abfall der Eingangsspannung Uin zunächst zu vermeiden.

Weiter weist die Offen-Zustands-Menge einen von dem Spannungssteuerungs-Zustand SZ verschiedenen Inaktiv-Zustand IZ zum Nicht-Begrenzen eines Anstiegs der Eingangsspannung Uin verursacht durch den auslaufenden Elektroantriebsmotor 6 auf, insbesondere bei offenem Schaltzustand open des Bedienschalters 2. Der Schritt b) weist auf: zeitlich nach dem Betreiben der Motoransteuerung 4 in dem Spannungssteuerungs-Zustand Betreiben der Motoransteuerung 4 in dem Inaktiv-Zustand IZ.

Zudem weist die Motoransteuerung 4 mindestens ein, insbesondere erstes, Motorschaltelement 12a und mindestens ein, insbesondere erstes, Schutzelement 13a, insbesondere eine Schutzdiode 14a, zum Schutz des Motorschaltelements 12a auf. Das, insbesondere erste, Schutzelement 13a ermöglicht einen Anstieg der Eingangsspannung Uin verursacht durch den auslaufenden Elektroantriebsmotor 6.

Im gezeigten Ausführungsbeispiel ist das, insbesondere erste, Schutzelement 13a antiparallel zu dem, insbesondere ersten, Motorschaltelement 12a elektrisch angeordnet.

Des Weiteren weist die Motoransteuerung 4 das ansteuerbare erste Motorschaltelement 12a und ein ansteuerbares zweites Motorschaltelement 12b auf. Das erste Motorschaltelement 12a ist nach dem Bedienschalter 2 und vor dem Elektroantriebsmotor 6 elektrisch angeordnet. Das zweite Motorschaltelement 12b ist parallel zu dem Elektroantriebsmotor 6 elektrisch angeordnet.

Das Betreiben der Motoransteuerung 4 in dem Aktiv-Zustand AZ weist auf: Steuern des ersten Motorschaltelements 12a abwechselnd in einen An-Zustand on und in einen Aus-Zustand off, insbesondere mittels Pulsweitenmodulation PWM, insbesondere mittels der Überwachungs- und Steuerungseinrichtung 15.

Zusätzlich weist das Betreiben der Motoransteuerung 4 in dem Spannungssteuerungs-Zustand SZ auf: Steuern des ersten Motorschaltelements 12a abwechselnd in den An-Zustand on und in den Aus-Zustand off, insbesondere mittels Pulsweitenmodulation PWM, insbesondere mittels der Überwachungs- und Steuerungseinrichtung 15.

Weiter zusätzlich weist das Betreiben der Motoransteuerung 4 in dem Inaktiv-Zustand IZ auf: Steuern des ersten Motorschaltelements 12a andauernd in den Aus-Zustand off, insbesondere mittels der Überwachungs- und Steuerungseinrichtung 15.

Weiter zusätzlich weist das Betreiben der Motoransteuerung 4 in dem Aktiv-Zustand AZ auf: Steuern des zweiten Motorschaltelements 12b abwechselnd in einen An-Zustand on und in einen Aus-Zustand off, insbesondere mittels Pulsweitenmodulation PWM, insbesondere mittels der Überwachungs- und Steuerungseinrichtung 15.

Weiter zusätzlich weist das Betreiben der Motoransteuerung 4 in dem Spannungssteuerungs-Zustand SZ auf: Steuern des zweiten Motorschaltelements 12b abwechselnd in den An-Zustand on und in den Aus-Zustand off, insbesondere mittels Pulsweitenmodulation PWM, insbesondere mittels der Überwachungs- und Steuerungseinrichtung 15.

Weiter zusätzlich weist das Betreiben der Motoransteuerung 4 in dem Inaktiv-Zustand IZ auf: Steuern des zweiten Motorschaltelements 12b andauernd in den Aus-Zustand off, insbesondere mittels der Überwachungs- und Steuerungseinrichtung 15.

Im gezeigten Ausführungsbeispiel weist das Betreiben der Motoransteuerung 4 in dem Aktiv-Zustand AZ und in dem Spannungssteuerungs-Zustand SZ auf: Steuern des ersten Motorschaltelements 12a und des zweiten Motorschaltelements 12b mittels komplementärer Pulsweitenmodulation PWM.

In alternativen Ausführungsbeispielen kann das Betreiben der Motoransteuerung in dem Spannungssteuerungs-Zustand aufweisen: Steuern des ersten Motorschaltelements andauernd in den Aus-Zustand.

Außerdem weist die Motoransteuerung 4 ein zweites Schutzelement 13b, insbesondere eine Schutzdiode 14b, zum Schutz des zweiten Motorschaltelements 12b auf.

Im gezeigten Ausführungsbeispiel ist das zweite Schutzelement 13b antiparallel zu dem zweiten Motorschaltelement 12b elektrisch angeordnet.

Weiter weist die Motorelektronik 3 mindestens einen Zwischenkreiskondensator 11 auf. Die Eingangsspannung Uin ist eine Zwischenkreisspannung U11 des mindestens einen Zwischenkreiskondensators 11.

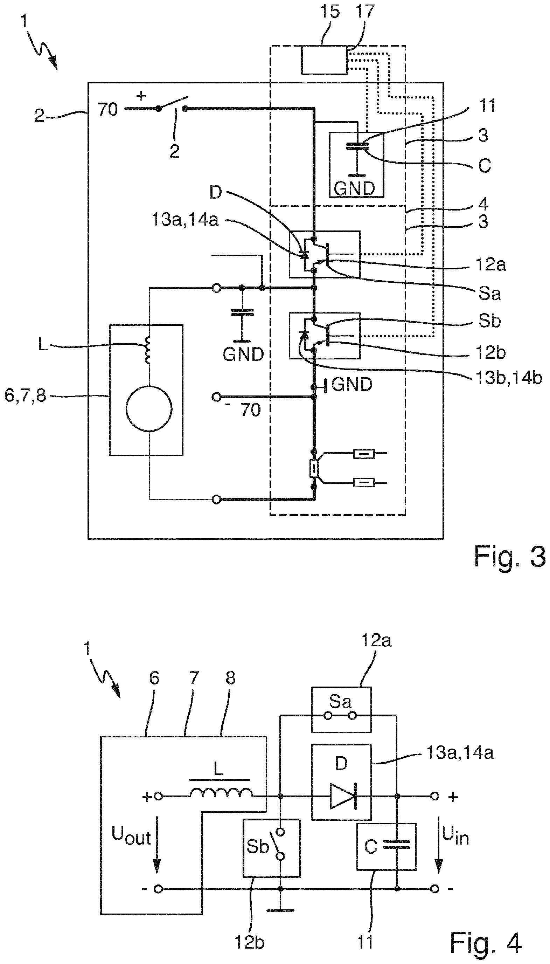

Im gezeigten Ausführungsbeispiel bilden der Zwischenkreiskondensator 11, die erste Schutzdiode 14a, das zweite Motorschaltelement 12b, das erste Motorschaltelement 12a und der Elektroantriebsmotor 6 einen Aufwärtswandler, wie in Fig. 4 gezeigt.

In alternativen Ausführungsbeispielen können der Zwischenkreiskondensator, die erste Schutzdiode, das zweite Motorschaltelement und der Elektroantriebsmotor einen Aufwärtswandler bilden.

Im Detail ist der Elektroantriebsmotor 6 als Induktivität L seriell mit der Schutzdiode 14a als Freilaufdiode D geschaltet, hinter welcher der Zwischenkreiskondensator 11 als Ladekondensator C die Ausgangsspannung Uout aufsummiert. Der Elektroantriebsmotor 6 als Induktivität L kann durch das zweite Motorschaltelement 12b als Schalter Sb gegen Masse GND geschaltet werden. Das zweite Motorschaltelement 12b als Schalter Sb wird dafür verwendet, um nach dem Aufwärtswandler-Prinzip die, insbesondere konstante, Eingangs-/Zwischenkreisspannung Uin, U11 aus der abfallenden Ausgangsspannung Uout, insbesondere des Elektroantriebsmotors 6, zu generieren. Das erste Motorschaltelement 12a als Schalter Sa wird in den An-Zustand on gesteuert, wenn das zweite Motorschaltelement 12b in den Aus-Zustand off gesteuert wird, damit die Eingangs-/Zwischenkreisspannung Uin, U11 nicht ansteigt verursacht durch den auslaufenden Elektroantriebsmotor 6, insbesondere verursacht durch die Kommutierungspeaks KP.

Somit ermöglicht das Verwenden der Motorelektronik 3, insbesondere der Motoransteuerung 4, als Aufwärtswandler und das Nutzen der induzierten Ausgangsspannung Uout des auslaufenden Elektroantriebsmotors 6 die Eingangsspannung Uin, insbesondere die Zwischenkreisspannung U11, auf dem Spannungswert U3, insbesondere dem zweiten Spannungsgrenzwert U2, zu halten.

Dies ermöglicht einen weiteren Abfall der Eingangsspannung Uin zunächst zu vermeiden. Somit ermöglicht dies bei erneuter Betätigung bzw. geschlossenem Schaltzustand closed des Bedienschalters 2 einen Einschaltstrom niedrig zu halten. Insbesondere kann dies ermöglichen, eine Beschädigung der Motorelektronik 3, insbesondere des Zwischenkreiskondensators 11, zu vermeiden.

Zusätzlich ermöglicht das Steuern in dem Aktiv-Zustand AZ bei geschlossenem Schaltzustand closed des Bedienschalters 2 das Versorgen des Elektroantriebsmotors 6 mit elektrischer Ausgangsleistung Pout von der Antriebsspannungsquelle 70 und/oder bei offenem Schaltzustand open des Bedienschalters 2 den Abfall der Eingangsspannung Uin, insbesondere der Zwischenkreisspannung U11, insbesondere ein Entladen des Zwischenkreiskondensators 11.

Weiter zusätzlich ermöglicht das Steuern in dem Spannungssteuerungs-Zustand SZ bei offenem Schaltzustand open des Bedienschalters 2 das Begrenzen des Anstiegs der Eingangsspannung Uin, insbesondere das Halten der Eingangsspannung Uin, und/oder bei geschlossenem Schaltzustand closed des Bedienschalters 2 das Zulassen des Anstiegs der Eingangsspannung Uin, insbesondere der Zwischenkreisspannung U11, insbesondere ein Aufladen des Zwischenkreiskondensators 11.

Weiter zusätzlich ermöglicht das Steuern in dem Inaktiv-Zustand IZ, insbesondere bei offenem Schaltzustand open des Bedienschalters 2, das Nicht-Begrenzen des Anstiegs der Eingangsspannung Uin, insbesondere der Zwischenkreisspannung U11, insbesondere ein Aufladen des Zwischenkreiskondensators 11.

Zudem ist im gezeigten Ausführungsbeispiel die Überwachungs- und Steuerungseinrichtung 15 zum Zusammenwirken mit dem ersten Motorschaltelement 12a, dem zweiten Motorschaltelement 12b und dem Zwischenkreiskondensator 11 ausgebildet, wie in Fig. 3 durch gestrichelte Linien angedeutet.

Des Weiteren weist das Verfahren den Schritt auf: falls das Geschlossen-Kriterium erfüllt ist, Ausführen eines Selbsttests des Bearbeitungsgeräts 1, insbesondere mittels einer Selbsttesteinrichtung 17 des Bearbeitungsgeräts 1, und/oder Ausgeben einer benutzerwahrnehmbaren Information If18, insbesondere mittels einer Ausgabeeinrichtung 18 des Bearbeitungsgeräts 1.

Im gezeigten Ausführungsbeispiel weist die Ausgabeeinrichtung 18 eine Ausgabeeinrichtung-Leiterplatte aufweisend eine Anzeige in Form einer Mehrzahl von LEDs auf.

Außerdem verbindet elektrisch im gezeigten Ausführungsbeispiel der Informationspfad 10 die Antriebsspannungsquelle 70 mit der Selbsttesteinrichtung 17 und/oder der Ausgabeeinrichtung 18 für einen Fluss von elektrischer Leistung P17, P18 von der Antriebsspannungsquelle 70 zu der Selbsttesteinrichtung 17 und/oder der Ausgabeeinrichtung 18 für einen Betreib der Selbsttesteinrichtung 17 und/oder der Ausgabeeinrichtung 18, insbesondere bei offenem Schaltzustand open des Bedienschalters 2.

Wie die gezeigten und oben erläuterten Ausführungsbeispiele deutlich machen, stellt die Erfindung ein vorteilhaftes Verfahren zum Betreiben eines elektrischen Bearbeitungsgeräts und ein vorteilhaftes elektrisches Bearbeitungsgerät bereit, das jeweils verbesserte Eigenschaften aufweist.

## Patentansprüche

1. Verfahren zum Betreiben eines elektrischen Bearbeitungsgeräts (1), wobei das Bearbeitungsgerät (1) aufweist:
- einen benutzerbetätigbaren Bedienschalter (2), eine Motorelektronik (3) aufweisend eine Motoransteuerung (4) und einen Elektroantriebsmotor (6),
- wobei der Bedienschalter (2) eingangsseitig mit einer Antriebsspannungsquelle (70) und ausgangsseitig mit der Motorelektronik (3) elektrisch verbunden ist, wobei der Bedienschalter (2) dazu ausgebildet ist, in einem geschlossenen Schaltzustand (closed) eine elektrische Verbindung zwischen der Antriebsspannungsquelle (70) und der Motorelektronik (3) herzustellen und in einem offenen Schaltzustand (open) zu trennen, wobei der Bedienschalter (2) ein trennender Schalter ist, und
- wobei die Motorelektronik (3) ausgangsseitig mittels der Motoransteuerung (4) mit dem Elektroantriebsmotor (6) elektrisch verbunden ist,
wobei das Verfahren die Schritte aufweist:
a) Überwachen, ob eine Eingangsspannung (Uin) an der Motorelektronik (3) ein Geschlossen-Kriterium (ck) oder ein Offen-Kriterium (ok) erfüllt, wobei das Geschlossen-Kriterium (ck) für den geschlossenen Schaltzustand (closed) des Bedienschalters (2) charakteristisch ist, und wobei das Offen-Kriterium (ok) für den offenen Schaltzustand (open) des Bedienschalters (2) charakteristisch ist, und
b) falls das Offen-Kriterium (ok) erfüllt ist, Betreiben der Motoransteuerung (4) in einem Zustand (SZ, IZ) aus einer Offen-Zustands-Menge, wobei die Offen-Zustands-Menge einen Spannungssteuerungs-Zustand (SZ) zum Begrenzen eines Anstiegs der Eingangsspannung (Uin) verursacht durch den auslaufenden Elektroantriebsmotor (6) aufweist,
- wobei durch das Verwenden der Motoransteuerung (4) als Aufwärtswandler und das Nutzen einer induzierten Ausgangsspannung (Uout) des auslaufenden Elektroantriebsmotors (6) die Eingangsspannung (Uin) auf einem Spannungswert (U3) gehalten wird.

2. Verfahren nach Anspruch 1,
- wobei der Elektroantriebsmotor (6) einen mechanischen Kommutator (7) aufweist, insbesondere eine Gleichstrommaschine (8) ist.

3. Verfahren nach einem der vorhergehenden Ansprüche,
- wobei das Geschlossen-Kriterium (ck) ist, dass die Eingangsspannung (Uin) gleich oder größer als ein erster Spannungsgrenzwert (U1) ist und/oder ein Anstieg der Eingangsspannung (Uin) gleich oder größer als ein Spannungsanstiegsgrenzwert ist, und/oder
- wobei das Offen-Kriterium (ok) ist, dass die Eingangsspannung (Uin) gleich oder kleiner als ein zweiter Spannungsgrenzwert (U2) ist und/oder ein Abfall der Eingangsspannung (Uin) gleich oder kleiner als ein Spannungsabfallgrenzwert ist.

4. Verfahren nach einem der vorhergehenden Ansprüche, insbesondere nach Anspruch 3,
- wobei das Bearbeitungsgerät (1) einen Leistungspfad (9) und einen von dem Leistungspfad (9) verschiedenen Informationspfad (10) aufweist,
- wobei der Leistungspfad (9) die Antriebsspannungsquelle (70) mit der Motorelektronik (3) eingangsseitig für einen Fluss von elektrischer Antriebsleistung (P7) von der Antriebsspannungsquelle (70) zu der Motorelektronik (3) elektrisch verbindet, und wobei der Bedienschalter (2) in dem Leistungspfad (9) elektrisch angeordnet ist, und
- wobei der Informationspfad (10) die Antriebspannungsquelle (70) mit der Motorelektronik (3) für eine Information (lfU7) über einen Spannungsquellenwert (U7) der Antriebspannungsquelle (70) elektrisch verbindet,
wobei das Verfahren den Schritt aufweist:
- Vorgeben des Geschlossen-Kriteriums (ck), insbesondere des ersten Spannungsgrenzwerts (U1) und/oder des Spannungsanstiegsgrenzwerts, und/oder des Offen-Kriteriums (ok), insbesondere des zweiten Spannungsgrenzwerts (U2) und/oder des Spannungsabfallgrenzwerts, in Abhängigkeit der bereitgestellten Information (lfU7) über den Spannungsquellenwert (U7).

5. Verfahren nach Anspruch 3 und/oder 4,
- wobei der zweite Spannungsgrenzwert (U2) kleiner als der erste Spannungsgrenzwert (U1) ist, insbesondere wobei der zweite Spannungsgrenzwert (U2) mindestens 0,75 V kleiner als der erste Spannungsgrenzwert (U1) ist und/oder in einem Bereich von 0,8-mal bis 0,9-mal des ersten Spannungsgrenzwerts (U1) liegt, und/oder
- wobei der erste Spannungsgrenzwert (U1) kleiner als der Spannungsquellenwert (U7) ist, insbesondere wobei der erste Spannungsgrenzwert (U1) mindestens 0,25 V kleiner als der Spannungsquellenwert (U7) ist und/oder in einem Bereich von 0,85-mal bis 0,95-mal des Spannungsquellenwerts (U7) liegt, und/oder
- wobei der erste Spannungsgrenzwert (U1) in einem Bereich von 7,5 V bis 20,5 V liegt, und/oder
- wobei der zweite Spannungsgrenzwert (U2) in einem Bereich von 6 V bis 20,5 V liegt, und/oder
- wobei der Spannungsquellenwert (U7) in einem Bereich von 8 V bis 20,5 V liegt.

6. Verfahren nach einem der vorhergehenden Ansprüche, wobei das Verfahren den Schritt aufweist:
c) falls das Geschlossen-Kriterium (ck) erfüllt ist, Betreiben der Motoransteuerung (4) in einem Aktiv-Zustand (AZ) zum Versorgen des Elektroantriebsmotors (6) mit elektrischer Ausgangsleistung (Pout) von der Antriebsspannungsquelle (70).

7. Verfahren nach einem der vorhergehenden Ansprüche,
- wobei die Offen-Zustands-Menge den Spannungssteuerungs-Zustand (SZ) zum Zulassen eines Anstiegs der Eingangsspannung (Uin) verursacht durch die Antriebsspannungsquelle (70) bei geschlossenem Schaltzustand (closed) des Bedienschalters (2) aufweist.

8. Verfahren nach einem der vorhergehenden Ansprüche,
- wobei die Offen-Zustands-Menge den Spannungssteuerungs-Zustand (SZ) zum Halten der Eingangsspannung (Uin) auf dem Spannungswert (U3) aufweist.

9. Verfahren nach einem der vorhergehenden Ansprüche,
- wobei die Offen-Zustands-Menge einen von dem Spannungssteuerungs-Zustand (SZ) verschiedenen Inaktiv-Zustand (IZ) zum Nicht-Begrenzen eines Anstiegs der Eingangsspannung (Uin) verursacht durch den auslaufenden Elektroantriebsmotor (6) aufweist, und
- wobei der Schritt b) aufweist: zeitlich nach dem Betreiben der Motoransteuerung (4) in dem Spannungssteuerungs-Zustand (SZ) Betreiben der Motoransteuerung (4) in dem Inaktiv-Zustand (IZ).

10. Verfahren nach einem der vorhergehenden Ansprüche,
- wobei die Motoransteuerung (4) mindestens ein Motorschaltelement (12a) und mindestens ein Schutzelement (13a), insbesondere eine Schutzdiode (14a), zum Schutz des Motorschaltelements (12a) aufweist, wobei das Schutzelement (13a) einen Anstieg der Eingangsspannung (Uin) verursacht durch den auslaufenden Elektroantriebsmotor (6) ermöglicht.

11. Verfahren nach einem der vorhergehenden Ansprüche, insbesondere nach Anspruch 6 und/oder 9,
- wobei die Motoransteuerung (4) ein ansteuerbares erstes Motorschaltelement (12a), wobei das erste Motorschaltelement (12a) nach dem Bedienschalter (2) und vor dem Elektroantriebsmotor (6) elektrisch angeordnet ist, und/oder ein ansteuerbares zweites Motorschaltelement (12b), wobei das zweite Motorschaltelement (12b) parallel zu dem Elektroantriebsmotor (6) elektrisch angeordnet ist, aufweist,
- wobei das Betreiben der Motoransteuerung (4) in dem Aktiv-Zustand (AZ) aufweist: Steuern des ersten Motorschaltelements (12a) abwechselnd in einen An-Zustand (on) und in einen Aus-Zustand (off), insbesondere mittels Pulsweitenmodulation (PWM), und/oder wobei das Betreiben der Motoransteuerung (4) in dem Spannungssteuerungs-Zustand (SZ) aufweist: Steuern des ersten Motorschaltelements (12a) abwechselnd in den An-Zustand (on) und in den Aus-Zustand (off), insbesondere mittels Pulsweitenmodulation (PWM), und/oder wobei das Betreiben der Motoransteuerung (4) in dem Inaktiv-Zustand (IZ) aufweist: Steuern des ersten Motorschaltelements (12a) andauernd in den Aus-Zustand (off), und/oder
- wobei das Betreiben der Motoransteuerung (4) in dem Aktiv-Zustand (AZ) ferner aufweist: Steuern des zweiten Motorschaltelements (12b) abwechselnd in einen An-Zustand (on) und in einen Aus-Zustand (off), insbesondere mittels Pulsweitenmodulation (PWM), und/oder wobei das Betreiben der Motoransteuerung (4) in dem Spannungssteuerungs-Zustand (SZ) aufweist: Steuern des zweiten Motorschaltelements (12b) abwechselnd in den An-Zustand (on) und in den Aus-Zustand (off), insbesondere mittels Pulsweitenmodulation (PWM), und/oder wobei das Betreiben der Motoransteuerung (4) in dem Inaktiv-Zustand (IZ) aufweist: Steuern des zweiten Motorschaltelements (12b) andauernd in den Aus-Zustand (off).

12. Verfahren nach einem der vorhergehenden Ansprüche,
- wobei die Motorelektronik (3) mindestens einen Zwischenkreiskondensator (11) aufweist, wobei die Eingangsspannung (Uin) eine Zwischenkreisspannung (U11) des mindestens einen Zwischenkreiskondensators (11) ist.

13. Verfahren nach einem der vorhergehenden Ansprüche, wobei das Verfahren den Schritt aufweist:
- falls das Geschlossen-Kriterium (ck) erfüllt ist, Ausführen eines Selbsttests des Bearbeitungsgeräts (1) und/oder Ausgeben einer benutzerwahrnehmbaren Information (If18).

14. Elektrisches Bearbeitungsgerät (1), insbesondere zum Ausführen eines Verfahrens nach einem der vorhergehenden Ansprüche, wobei das Bearbeitungsgerät (1) aufweist:
- einen benutzerbetätigbaren Bedienschalter (2), eine Motorelektronik (3) aufweisend eine Motoransteuerung (4) und aufweisend eine Überwachungs- und Steuerungseinrichtung (15) und einen Elektroantriebsmotor (6),
- wobei der Bedienschalter (2) eingangsseitig zum elektrischen Verbinden mit einer Antriebsspannungsquelle (70) ausgebildet ist und ausgangsseitig mit der Motorelektronik (3) elektrisch verbunden ist, wobei der Bedienschalter (2) dazu ausgebildet ist, in einem geschlossenen Schaltzustand (closed) eine elektrische Verbindung zwischen der Antriebsspannungsquelle (70) und der Motorelektronik (3) herzustellen und in einem offenen Schaltzustand (open) zu trennen, wobei der Bedienschalter (2) ein trennender Schalter ist, und
- wobei die Motorelektronik (3) ausgangsseitig mittels der Motoransteuerung (4) mit dem Elektroantriebsmotor (6) elektrisch verbunden ist, und
- wobei die Überwachungs- und Steuerungseinrichtung (15)
- zum Überwachen, ob eine Eingangsspannung (Uin) an der Motorelektronik (3) ein Geschlossen-Kriterium (ck) oder ein Offen-Kriterium (ok) erfüllt, wobei das Geschlossen-Kriterium (ck) für den geschlossenen Schaltzustand (closed) des Bedienschalters (2) charakteristisch ist, und wobei das Offen-Kriterium (ok) für den offenen Schaltzustand (open) des Bedienschalters (2) charakteristisch ist, und
- falls das Offen-Kriterium (ok) erfüllt ist, zum Betreiben der Motoransteuerung (4) in einem Zustand (SZ, IZ) aus einer Offen-Zustands-Menge, wobei die Offen-Zustands-Menge einen Spannungssteuerungs-Zustand (SZ) zum Begrenzen eines Anstiegs der Eingangsspannung (Uin) verursacht durch den auslaufenden Elektroantriebsmotor (6) aufweist, ausgebildet ist,
- wobei die Überwachungs- und Steuerungseinrichtung (15) dazu ausgebildet ist, dass durch das Verwenden der Motoransteuerung (4) als Aufwärtswandler und das Nutzen einer induzierten Ausgangsspannung (Uout) des auslaufenden Elektroantriebsmotors (6) die Eingangsspannung (Uin) auf einem Spannungswert (U3) gehalten wird.

15. Elektrisches Bearbeitungsgerät (1) nach Anspruch 14, wobei das Bearbeitungsgerät (1) aufweist:
- die Antriebsspannungsquelle (70), insbesondere wobei die Antriebsspannungsquelle (70) einen Akkumulator (19) aufweist.

## Claims

1. Method for operating an electrical treatment device (1), wherein the treatment device (1) has:
- a user-operable operating switch (2), a motor electronics system (3) having a motor control (4) and an electric drive motor (6),
- wherein the operating switch (2) is electrically connected to a drive voltage source (70) on the input side and to the motor electronics system (3) on the output side, wherein the operating switch (2) is designed to produce an electrical connection between the drive voltage source (70) and the motor electronics system (3) in a closed switching state (closed), and to disconnect it in an open switching state (on), wherein the operating switch (2) is a disconnecting switch, and
- wherein the motor electronics system (3) is electrically connected to the electric drive motor (6) on the output side by means of the motor control (4),
wherein the method includes the steps:
a) monitoring whether an input voltage (Uin) at the motor electronics system (3) meets a closed criterion (ck) or an open criterion (ok), wherein the closed criterion (ck) is characteristic of the closed switching state (closed) of the operating switch (2), and wherein the open criterion (ok) is characteristic of the open switching state (open) of the operating switch (2), and
b) if the open criterion (ok) is met, operating the motor control (4) in a state (SZ, IZ) from an open state set, wherein the open state set includes a voltage control state (SZ) for limiting an increase in the input voltage (Uin) caused by the running-down electric drive motor (6),
- wherein by the use of the motor control (4) as a step-up converter and the use of an induced output voltage (Uout) of the running-down electric drive motor (6) the input voltage (Uin) is maintained at a voltage value (U3).

2. Method according to Claim 1,
- wherein the electric drive motor (6) has a mechanical commutator (7), in particular is a direct current machine (8).

3. Method according to one of the preceding claims,
- wherein the closed criterion (ck) is that the input voltage (Uin) is equal to or greater than a first voltage threshold value (U1) and/or that an increase in the input voltage (Uin) is equal to or greater than a voltage increase threshold value, and/or
- wherein the open criterion (ok) is that the input voltage (Uin) is equal to or smaller than a second voltage threshold value (U2) and/or that a drop in the input voltage (Uin) is equal to or smaller than a voltage drop threshold value.

4. Method according to one of the preceding claims, in particular according to Claim 3,
- wherein the treatment device (1) has a power path (9) and an information path (10) which is different from the power path (9),
- wherein the power path (9) electrically connects the drive voltage source (70) to the motor electronics system (3) on the input side for a flow of electric drive power (P7) from the drive voltage source (70) to the motor electronics system (3), and wherein the operating switch (2) is arranged in an electrical manner in the power path (9), and
- wherein the information path (10) electrically connects the drive voltage source (70) to the motor electronics system (3) for information (IfU7) regarding a voltage source value (U7) of the drive voltage source (70),
wherein the method includes the step:
- specifying the closed criterion (ck), in particular the first voltage threshold value (U1) and/or the voltage increase threshold value, and/or the open criterion (ok), in particular the second voltage threshold value (U2) and/or the voltage drop threshold value, depending on the information (IfU7) provided regarding the voltage source value (U7).

5. Method according to Claim 3 and/or 4,
- wherein the second voltage threshold value (U2) is smaller than the first voltage threshold value (U1), in particular wherein the second voltage threshold value (U2) is at least 0.75 V smaller than the first voltage threshold value (U1) and/or falls within a range from 0.8 times to 0.9 times the first voltage threshold value (U1), and/or
- wherein the first voltage threshold value (U1) is smaller than the voltage source value (U7), in particular wherein the first voltage threshold value (U1) is at least 0.25 V smaller than the voltage source value (U7) and/or falls within a range from 0.85 times to 0.95 times the voltage source value (U7), and/or
- wherein the first voltage threshold value (U1) falls within a range from 7.5 V to 20.5 V, and/or
- wherein the second voltage threshold value (U2) falls within a range from 6 V to 20.5 V, and/or
- wherein the voltage source value (U7) falls within a range from 8 V to 20.5 V.

6. Method according to one of the preceding claims, wherein the method includes the step:
c) if the closed criterion (ck) is met, operating the motor control (4) in an active state (AZ) for supplying the electric drive motor (6) with electrical output power (Pout) from the drive voltage source (70).

7. Method according to one of the preceding claims,
- wherein the open state set includes the voltage control state (SZ) for permitting an increase in the input voltage (Uin) caused by the drive voltage source (70) in the closed switching state (closed) of the operating switch (2).

8. Method according to one of the preceding claims,
- wherein the open state set includes the voltage control state (SZ) for maintaining the input voltage (Uin) at the voltage value (U3).

9. Method according to one of the preceding claims,
- wherein the open state set includes an inactive state (IZ) which is different from the voltage control state (SZ) for not limiting an increase in the input voltage (Uin) caused by the running-down electric drive motor (6), and
- wherein step b) includes: temporally after operating the motor control (4) in the voltage control state (SZ), operating the motor control (4) in the inactive state (IZ).

10. Method according to one of the preceding claims,
- wherein the motor control (4) has at least one motor switch element (12a) and at least one protective element (13a), in particular a protective diode (14a), for protecting the motor switch element (12a), wherein the protective element (13a) enables an increase in the input voltage (Uin) caused by the running-down electric drive motor (6) .

11. Method according to one of the preceding claims, in particular according to Claim 6 and/or 9,
- wherein the motor control (4) has a controllable first motor switch element (12a), wherein the first motor switch element (12a) is arranged in an electrical manner after the operating switch (2) and before the electric drive motor (6), and/or a controllable second motor switch element (12b), wherein the second motor switch element (12b) is arranged in an electrical manner parallel to the electric drive motor (6),
- wherein operating the motor control (4) in the active state (AZ) includes: controlling the first motor switch element (12a) alternately in an on state (on) and in an off state (off), in particular by means of pulse width modulation (PWM), and/or wherein operating the motor control (4) in the voltage control state (SZ) includes: controlling the first motor switch element (12a) alternately in the on state (on) and in the off state (off), in particular by means of pulse width modulation (PWM), and/or wherein operating the motor control (4) in the inactive state (IZ) includes: controlling the first motor switch element (12a) continuously in the off state (off), and/or
- wherein operating the motor control (4) in the active state (AZ) further includes: controlling the second motor switch element (12b) alternately in an on state (on) and in an off state (off), in particular by means of pulse width modulation (PWM), and/or wherein operating the motor control (4) in the voltage control state (SZ) includes: controlling the second motor switch element (12b) alternately in the on state (on) and in the off state (off), in particular by means of pulse width modulation (PWM), and/or wherein operating the motor control (4) in the inactive state (IZ) includes: controlling the second motor switch element (12b) continuously in the off state (off).

12. Method according to one of the preceding claims,
- wherein the motor electronics system (3) has at least one intermediate circuit capacitor (11), wherein the input voltage (Uin) is an intermediate circuit voltage (U11) of the at least one intermediate circuit capacitor (11).

13. Method according to one of the preceding claims, wherein the method includes the step:
- if the closed criterion (ck) is met, performing a self-test of the treatment device (1) and/or outputting user-accessible information (If18).

14. Electrical treatment device (1), in particular for performing a method according to one of the preceding claims, wherein the treatment device (1) has:
- a user-operable operating switch (2), a motor electronics system (3) having a motor control (4) and having a monitoring and control apparatus (15) and an electric drive motor (6),
- wherein the operating switch (2) is designed to electrically connect to a drive voltage source (70) on the input side and is electrically connected to the motor electronics system (3) on the output side, wherein the operating switch (2) is designed to produce an electrical connection between the drive voltage source (70) and the motor electronics system (3) in a closed switching state (closed), and to disconnect it in an open switching state (on), wherein the operating switch (2) is a disconnecting switch, and
- wherein the motor electronics system (3) is electrically connected to the electric drive motor (6) on the output side by means of the motor control (4), and
- wherein the monitoring and control apparatus (15) is designed
- to monitor whether an input voltage (Uin) at the motor electronics system (3) meets a closed criterion (ck) or an open criterion (ok), wherein the closed criterion (ck) is characteristic of the closed switching state (closed) of the operating switch (2), and wherein the open criterion (ok) is characteristic of the open switching state (open) of the operating switch (2), and
- if the open criterion (ok) is met, to operate the motor control (4) in a state (SZ, IZ) from an open state set, wherein the open state set includes a voltage control state (SZ) for limiting an increase in the input voltage (Uin) caused by the running-down electric drive motor (6),
- wherein the monitoring and control apparatus (15) is designed that by the use of the motor control (4) as a step-up converter and the use of an induced output voltage (Uout) of the running-down electric drive motor (6) the input voltage (Uin) is maintained at a voltage value (U3).

15. Electrical treatment device (1) according to Claim 14, wherein the treatment device (1) has:
- the drive voltage source (70), in particular wherein the drive voltage source (70) has an accumulator (19).

## Revendications

1. Procédé pour faire fonctionner un appareil d'usinage (1) électrique, l'appareil d'usinage (1) comprenant :
- un commutateur de conduite (2) actionnable par l'utilisateur, une électronique de moteur (3) possédant une commande de moteur (4) et un moteur d'entraînement électrique (6),
- le commutateur de conduite (2) étant relié électriquement du côté de l'entrée à une source de tension d'entraînement (70) et du côté de la sortie à l'électronique de moteur (3), le commutateur de conduite (2) étant configuré pour, dans un état de commutation fermé (closed), établir une liaison électrique entre la source de tension d'entraînement (70) et l'électronique de moteur (3) et la couper dans un état de commutation ouvert (open), le commutateur de conduite (2) étant un commutateur séparateur, et
- l'électronique de moteur (3) étant reliée électriquement du côté de la sortie au moteur d'entraînement électrique (6) au moyen de la commande de moteur (4),
le procédé comprenant les étapes suivantes :
a) surveillance si une tension d'entrée (Uin) au niveau de l'électronique de moteur (3) satisfait un critère de fermeture (ck) ou un critère d'ouverture (ok), le critère de fermeture (ck) étant caractéristique de l'état de commutation fermé (closed) du commutateur de conduite (2) et le critère d'ouverture (ok) étant caractéristique de l'état de commutation ouvert (open) du commutateur de conduite (2), et
b) dans le cas où le critère d'ouverture (ok) est satisfait, mise en fonctionnement de la commande de moteur (4) dans un état (SZ, IZ) parmi une quantité d'états ouverts, la quantité d'états ouverts présentant un état de commande de tension (SZ) destiné à limiter un accroissement de la tension d'entrée (Uin) provoqué par le moteur d'entraînement électrique (6) en train de ralentir,
- l'utilisation de la commande de moteur (4) en tant que convertisseur élévateur et l'utilisation d'une tension de sortie (Uout) induite du moteur d'entraînement électrique (6) en train de ralentir permettant de maintenir la tension d'entrée (Uin) à une valeur de tension (U3).

2. Procédé selon la revendication 1,
- le moteur d'entraînement électrique (6) possédant un collecteur mécanique (7), étant notamment une machine à courant continu (8).

3. Procédé selon l'une des revendications précédentes,
- le critère de fermeture (ck) étant que la tension d'entrée (Uin) est égale ou supérieure à une première valeur de tension (U1) et/ou un accroissement de la tension d'entrée (Uin) étant égal ou supérieur à une valeur limite d'accroissement de tension, et/ou
- le critère d'ouverture (ok) étant que la tension d'entrée (Uin) est inférieure ou égale à une deuxième valeur de tension (U2) et/ou une chute de la tension d'entrée (Uin) étant inférieure ou égale à une valeur limite de chute de tension.

4. Procédé selon l'une des revendications précédentes, notamment selon la revendication 3,
- l'appareil d'usinage (1) possédant un chemin de puissance (9) et un chemin d'information (10) différent du chemin de puissance (9),
- le chemin de puissance (9) reliant électriquement la source de tension d'entraînement (70) à l'électronique de moteur (3) du côté de l'entrée pour un flux de puissance d'entraînement électrique (P7) de la source de tension d'entraînement (70) vers l'électronique de moteur (3), et le commutateur de conduite (2) étant disposé électriquement dans le chemin de puissance (9), et
- le chemin d'information (10) reliant électriquement la source de tension d'entraînement (70) à l'électronique de moteur (3) pour une information (IfU7) à propos d'une valeur de source de tension (U7) de la source de tension d'entraînement (70),
le procédé comprenant l'étape suivante :
- prédéfinition du critère de fermeture (ck), notamment de la première valeur limite de tension (U1) et/ou de la valeur limite d'accroissement de tension, et/ou du critère d'ouverture (ok), notamment de la deuxième valeur limite de tension (U2) et/ou de la valeur limite de chute de tension, en fonction de l'information (IfU7) mise à disposition à propos de la valeur de source de tension (U7).

5. Procédé selon la revendication 3 et/ou 4,
- la deuxième valeur limite de tension (U2) étant inférieure à la première valeur limite de tension (U1), la deuxième valeur limite de tension (U2) étant notamment inférieure d'au moins 0,75 V à la première valeur limite de tension (U1) et/ou se trouvant dans une plage de 0,8 fois à 0,9 fois la première valeur limite de tension (U1), et/ou
- la première valeur limite de tension (U1) étant inférieure à la valeur de seuil de tension (U7), la première valeur limite de tension (U1) étant notamment inférieure d'au moins 0,25 V à la valeur de seuil de tension (U7) et/ou se trouvant dans une plage de 0,85 fois à 0,95 fois la valeur de seuil de tension (U7), et/ou
- la première valeur limite de tension (U1) se trouvant dans une plage de 7,5 V à 20,5 V, et/ou
- la deuxième valeur limite de tension (U2) se trouvant dans une plage de 6 V à 20,5 V, et/ou
- la valeur de seuil de tension (U7) se trouvant dans une plage de 8 V à 20,5 V.

6. Procédé selon l'une des revendications précédentes, le procédé comprenant l'étape suivante :
c) dans le cas où le critère de fermeture (ck) est satisfait, mise en fonctionnement de la commande de moteur (4) dans un état actif (AZ) pour alimenter le moteur d'entraînement électrique (6) avec de la puissance de sortie (Pout) électrique à partir de la source de tension d'entraînement (70).

7. Procédé selon l'une des revendications précédentes,
- la quantité d'états ouverts présentant l'état de commande de tension (SZ) destiné à autoriser un accroissement de la tension d'entrée (Uin) provoqué par la source de tension d'entraînement (70) à l'état de commutation fermé (closed) du commutateur de conduite (2) .

8. Procédé selon l'une des revendications précédentes,
- la quantité d'états ouverts présentant l'état de commande de tension (SZ) destiné à stopper la tension d'entrée (Uin) à la valeur de tension (U3).

9. Procédé selon l'une des revendications précédentes,
- la quantité d'états ouverts présentant un état inactif (IZ), différent de l'état de commande de tension (SZ), destiné à ne pas limiter un accroissement de la tension d'entrée (Uin) provoqué par le moteur d'entraînement électrique (6) en train de ralentir, et
- l'étape b) comprenant : chronologiquement après la mise en fonctionnement de la commande de moteur (4) dans l'état de commande de tension (SZ), mise en fonctionnement de la commande de moteur (4) dans l'état inactif (IZ).

10. Procédé selon l'une des revendications précédentes,
- la commande de moteur (4) possédant au moins un élément de commutation de moteur (12a) et au moins un élément de protection (13a), notamment une diode de protection (14a), destiné à protéger l'élément de commutation de moteur (12a), l'élément de protection (13a) rendant possible un accroissement de la tension d'entrée (Uin) provoqué par le moteur d'entraînement électrique (6) en train de ralentir.

11. Procédé selon l'une des revendications précédentes, notamment selon la revendication 6 et/ou 9,
- la commande de moteur (4) possédant un premier élément de commutation de moteur (12a) commandable, le premier élément de commutation de moteur (12a) étant disposé électriquement après le commutateur de conduite (2) et avant le moteur d'entraînement électrique (6), et/ou un deuxième élément de commutation de moteur (12b) commandable, le deuxième élément de commutation de moteur (12b) étant disposé électriquement en parallèle avec le moteur d'entraînement électrique (6),
- la mise en fonctionnement de la commande de moteur (4) dans l'état actif (AZ) comprenant : commande du premier élément de commutation de moteur (12a) en alternance dans un état Marche (on) et dans un état Arrêt (off), notamment au moyen de la modulation d'impulsions en largeur (PWM), et/ou la mise en fonctionnement de la commande de moteur (4) dans l'état de commande de tension (SZ) comprenant : commande du premier élément de commutation de moteur (12a) en alternance dans un état Marche (on) et dans un état Arrêt (off), notamment au moyen de la modulation d'impulsions en largeur (PWM), et/ou la mise en fonctionnement de la commande de moteur (4) dans l'état inactif (IZ) comprenant : commande du premier élément de commutation de moteur (12a) continuellement dans l'état Arrêt (off), et/ou
- la mise en fonctionnement de la commande de moteur (4) dans l'état actif (AZ) comprenant en outre : commande du deuxième élément de commutation de moteur (12b) en alternance dans un état Marche (on) et dans un état Arrêt (off), notamment au moyen de la modulation d'impulsions en largeur (PWM), et/ou la mise en fonctionnement de la commande de moteur (4) dans l'état de commande de tension (SZ) comprenant : commande du deuxième élément de commutation de moteur (12b) en alternance dans un état Marche (on) et dans un état Arrêt (off), notamment au moyen de la modulation d'impulsions en largeur (PWM), et/ou la mise en fonctionnement de la commande de moteur (4) dans l'état inactif (IZ) comprenant : commande du deuxième élément de commutation de moteur (12b) continuellement dans l'état Arrêt (off).

12. Procédé selon l'une des revendications précédentes,
- l'électronique de moteur (3) possédant au moins un condensateur de circuit intermédiaire (11), la tension d'entrée (Uin) étant une tension de circuit intermédiaire (U11) de l'au moins un condensateur de circuit intermédiaire (11).

13. Procédé selon l'une des revendications précédentes, le procédé comprenant l'étape suivante :
- dans le cas où le critère de fermeture (ck) est satisfait, exécution d'un auto-test de l'appareil d'usinage (1) et/ou délivrance d'une information (If18) perceptible par l'utilisateur.

14. Appareil d'usinage (1) électrique, notamment destiné à mettre en œuvre un procédé selon l'une des revendications précédentes, l'appareil d'usinage (1) comprenant :
- un commutateur de conduite (2) actionnable par l'utilisateur, une électronique de moteur (3) possédant une commande de moteur (4) et possédant un dispositif de surveillance et de commande (15) et un moteur d'entraînement électrique (6),
- le commutateur de conduite (2) étant configuré du côté de l'entrée pour être relié électriquement à une source de tension d'entraînement (70) et étant relié électriquement du côté de la sortie à l'électronique de moteur (3), le commutateur de conduite (2) étant configuré pour, dans un état de commutation fermé (closed), établir une liaison électrique entre la source de tension d'entraînement (70) et l'électronique de moteur (3) et la couper dans un état de commutation ouvert (open), le commutateur de conduite (2) étant un commutateur séparateur, et
- l'électronique de moteur (3) étant reliée électriquement du côté de la sortie au moteur d'entraînement électrique (6) au moyen de la commande de moteur (4),
- le dispositif de surveillance et de commande (15) étant configuré
- pour surveiller si une tension d'entrée (Uin) au niveau de l'électronique de moteur (3) satisfait un critère de fermeture (ck) ou un critère d'ouverture (ok), le critère de fermeture (ck) étant caractéristique de l'état de commutation fermé (closed) du commutateur de conduite (2) et le critère d'ouverture (ok) étant caractéristique de l'état de commutation ouvert (open) du commutateur de conduite (2), et
- dans le cas où le critère d'ouverture (ok) est satisfait, pour mettre en fonctionnement la commande de moteur (4) dans un état (SZ, IZ) parmi une quantité d'états ouverts, la quantité d'états ouverts présentant un état de commande de tension (SZ) destiné à limiter un accroissement de la tension d'entrée (Uin) provoqué par le moteur d'entraînement électrique (6) en train de ralentir,
- le dispositif de surveillance et de commande (15) étant configuré de sorte que l'utilisation de la commande de moteur (4) en tant que convertisseur élévateur et l'utilisation d'une tension de sortie (Uout) induite du moteur d'entraînement électrique (6) en train de ralentir permette de maintenir la tension d'entrée (Uin) à une valeur de tension (U3).

15. Appareil d'usinage (1) électrique selon la revendication 14, l'appareil d'usinage (1) possédant :
- la source de tension d'entraînement (70), la source de tension d'entraînement (70) possédant notamment un accumulateur (19).
